# EUROPEAN PATENT SPECIFICATION

(11) **EP 2 380 930 B1**
(45) Date of publication and mention of the grant of the patent: **12.09.2012**
(21) Application number: 11160325.4
(22) Date of filing: 30.03.2011
(51) Int. Cl.: C08L 23/22, C09D 123/22, C09J 123/22, H01L 31/042

(54) **Sealing composition, multiple glass and solar cell panel**
Abdichtzusammensetzung, mehrfaches Glas und Solarzellentafel
Composition d'étanchéité, vitre multiple et panneau de cellule solaire

(30) Priority: 09.04.2010 JP 2010090757
(43) Date of publication of application: 26.10.2011
(73) Proprietor: NITTO DENKO CORPORATION, Ibaraki-shi, Osaka 567-8680 (JP)
(72) Inventor: Fujii, Hiroki, Osaka 567-8680 (JP); Taga, Tetsuro, Osaka 567-8680 (JP); Mitsuoka, Yoshiaki, Osaka 567-8680 (JP)
(74) Representative: Schwabe - Sandmair - Marx

(56) References cited:
- WO-A1-2009/037962
- WO-A2-2009/148722
- JP-A- 2003 096 440
- JP-A- 2004 095 248
- JP-A- 2009 084 464
- US-A1- 2002 026 955
- US-A1- 2007 270 541

## Description

### BACKGROUND OF THE INVENTION

### Field of the Invention

The present invention relates to a sealing composition, multiple glass and a solar cell panel, and more specifically, it relates to a sealing composition employed for sealing various industrial products, as well as multiple glass and a solar cell panel each having an end portion sealed with the sealing composition.

### Description of Related Art

It is widely known that a seal material is provided on an end portion of an industrial product, in order to prevent fluid such as water or moisture from infiltrating thereinto.

As such a seal material, a sealing material containing polyisobutylene having a viscosity average molecular weight in the range of 50,000 to 90,000 and an inorganic filler is proposed, for example (refer to Japanese Unexamined Patent Publication No. 2006-117758, for example). In Japanese Unexamined Patent Publication No. 2006-117758, it is proposed to employ the sealing material for a solar panel.

In order to provide the sealing material proposed in Japanese Unexamined Patent Publication No. 2006-117758 on an end portion of a solar panel, the sealing material in a state heated to be reduced in viscosity is first applied to an end portion of one panel member of the solar panel and thereafter melted by heating, and another panel member is combined with the panel member. Thereafter the sealing material is cooled at ordinary temperature.

On the other hand, a sealant composition containing butyl-based rubber and crystalline polyolefin is proposed, for example (refer to Japanese Unexamined Patent Publication No. 10-110072, for example).

In the solar panel, a sealer made of EVA is arranged inside the seal material provided between the panel members, in order to seal a solar cell element.

### SUMMARY OF THE INVENTION

In the sealing material proposed in Japanese Unexamined Patent Publication No. 2006-117758, however, shape followability (adhesiveness) at ordinary temperature is so low that the sealing material must be temporarily heated to a high temperature to be melted and thereafter cooled when combined with the other panel member. In the sealing material, further, time for the heating and the cooling is separately needed.

When combined with the other panel member, in addition, the sealing material is melted by high-temperature heating for laminating the sealer made of EVA, and hence the sealing material disadvantageously extrudes from the end portion of the panel member, to drip and contaminate a sealing apparatus or the like.

The sealant composition proposed in Japanese Unexamined Patent Publication No. 10-110072 so easily adsorbs water or moisture that the same is reduced in insulation property. Further, the sealant composition is insufficient in durability against active rays such as ultraviolet rays, and reduced in insulation property when exposed to such rays over a long period. Therefore, electricity generated in the solar panel easily leaks to disadvantageously reduce the power generation efficiency.

An object of the present invention is to provide a sealing composition capable of easily and efficiently sealing various industrial products, particularly an end portion of multiple glass and a solar cell panel, and excellent in insulation property, water resistance, water vapor barrier property and durability, as well as multiple glass and a solar cell panel each having an end portion sealed with the sealing composition.

The sealing composition according to the present invention contains a rubber component and polyolefin, wherein the rubber component contains butyl rubber and polyisobutylene having a viscosity average molecular weight in the range of 500,000 to3,000,000, the mixing ratio of the rubber component to 100 parts by weight of the total amount of the rubber component and the polyolefin is in the range of 40 to 90 parts by weight, and the sealing composition contains 0 to 30 parts by weight of a hygroscopic compound with respect to 100 parts by weight of the total amount of the rubber component and the polyolefin.

In the sealing composition according to the present invention, it is preferable that the polyolefin is at least one type selected from polyethylene, polypropylene and an ethylene-propylene copolymer.

It is preferable that the sealing composition according to the present invention contains a filler in the range of 1 to 100 parts by weight with respect to 100 parts by weight of the total amount of the rubber component and the polyolefin, and it is preferable that the filler is at least one type selected from a group consisting of calcium carbonate, talc, titanium oxide and carbon black.

In the sealing composition according to the present invention, it is preferable that the hygroscopic compound is at least one type selected from a group consisting of silica gel, alumina and zeolite.

It is preferable that the sealing composition according to the present invention contains a tackifier, and it is preferable that the tackifier contains coumarone resin having a softening point of 90 to 140°C and/or polyisobutylene having a viscosity average molecular weight of 30,000 to 60,000 each in the range of 1 to 30 parts by weight with respect to 100 parts by weight of the total amount of the rubber component and the polyolefin.

It is preferable that the sealing composition according to the present invention is employed for sealing an end portion of multiple glass.

The multiple glass according to the present invention includes two glass layers arranged at an interval from each other in the thickness direction, an intermediate layer provided between the respective glass layers and arranged inside end portions of the glass layers, and a sealing material, filled into the gap between the end portions of the respective glass layers to seal the intermediate layer, made of the aforementioned sealing composition.

It is preferable that the sealing composition according to the present invention is employed for sealing an end portion of a solar cell panel.

The solar cell panel according to the present invention includes a glass layer, a support layer arranged at an interval from the glass layer in the thickness direction, a solar cell element provided between the glass layer and the support layer and arranged inside end portions of the glass layer and the support layer and a sealing resin layer sealing the solar cell element, and a seal material, filled into the gap between the end portions of the glass layer and the support layer to seal the sealing resin layer, made of the aforementioned sealing composition.

The seal material made of the sealing composition according to the present invention is excellent in shape followability at ordinary temperature, whereby the same can be set on a glass layer at ordinary temperature. Therefore, the seal material can be prevented from extruding from an end portion when the same is melted by heating, and can reliably seal various industrial products, particularly an end portion of multiple glass and a solar cell panel.

Further, the sealing composition is excellent in insulation property, water resistance, water vapor barrier property and durability, whereby the same can impart excellent insulation property, water resistance, water vapor barrier property and durability to the end portions of the multiple glass and the solar cell panel, for preventing the multiple glass and the solar cell panel from reduction in performance.

Particularly in the solar cell panel according to the present invention, reduction of power generation efficiency can be effectively prevented.

### BRIEF DESCRIPTION OF THE DRAWINGS

FIG. 1 is a sectional view of an embodiment of a seal material made of a sealing composition according to the present invention.
FIGS. 2(a), 2(b) and 2(c) are a sectional view, a plan view and a partially fragmented perspective view of an embodiment (implementation in which four seal materials are provided) of multiple glass according to the present invention respectively.
FIGS. 3(a), 3(b), 3(c) and 3(d) illustrate steps of preparing an upper-side glass layer, arranging a sealing resin layer, arranging a seal material and arranging a lower-side glass layer included in a method of producing the multiple glass shown in FIG. 2(a) respectively.
FIG. 4 is a plan view of a solar cell module (implementation in which one seal material is provided).
FIGS. 5(a), 5(b) and 5(c) are a sectional view, a plan view and a partially fragmented perspective view of an embodiment of a solar cell panel according to the present invention respectively.
FIGS. 6(a), 6(b), 6(c), 6(d) and 6(e) illustrate steps of preparing an upper-side glass layer, arranging a solar cell element, arranging a sealing resin layer, arranging a seal material and arranging a lower-side glass layer included in a method of producing the solar cell panel shown in FIG. 5(a) respectively.
FIG. 7 is a partially enlarged sectional view of a frameless solar cell module (a frameless solar cell module provided with a second seal material) including the solar cell panel shown in FIGS. 5(a) to 5(c).
FIGS. 8(a) and 8(b) are a partially enlarged sectional view and a partially fragmented perspective view of a solar cell module (a solar cell module provided with a frame) including the solar cell panel shown in FIGS. 5(a) to 5(c) respectively.
FIG. 9 is a graph showing the relation between moisture absorption time and volume resistivity in a high temperature and humidity resistance test of Examples and Comparative Examples.
FIG. 10 is a graph showing the relation between completion time and rate of weight change in a moisture resistance test of Examples and Comparative Examples.
FIG. 11 is a sectional view of a measuring apparatus employed for a water vapor barrier property test B of Examples and Comparative Examples.
FIG. 12 is a graph showing the relation between completion time and weight change in the water vapor barrier property test B of Examples and Comparative Examples.
FIG. 13 is a graph showing the relation between irradiation time and volume resistivity in an ultraviolet irradiation resistance test of Examples and Comparative Examples.
FIGS. 14(a) and 14(b) are sectional views of multiple glass before and after an anti-extrusion test of Examples and Comparative Examples respectively.
FIGS. 15(a) and 15(b) are sectional views of multiple glass before and after a contraction resistance test of Examples and Comparative Examples respectively.

### DETAILED DESCRIPTION OF PREFERRED EMBODIMENTS

The sealing composition according to the present invention, employed for sealing various industrial products, contains a rubber component and polyolefin.

The rubber component contains butyl rubber and polyisobutylene.

The butyl rubber is a copolymer (isobutylene-isoprene rubber) of isobutene (isobutylene) and a small quantity of isoprene, and a rubber elastic body having a high water vapor barrier property.

The degree of unsaturation of the butyl rubber is in the range of, e.g., 0.6 to 2.5 mole %, or preferably 0.7 to 2.0 mole %. The degree of unsaturation of the butyl rubber is measured by iodine adsorption method.

The Mooney viscosity of the butyl rubber is in the range of, e.g., 20 to 70 (ML₁₊₈, 125°C), or preferably 30 to 60 (ML₁₊₈, 125°C).

The viscosity average molecular weight of the butyl rubber is in the range of, e.g., 300,000 to 700,000, or preferably 300,000 to 500,000.

The viscosity average molecular weight is measured by size-exclusion chromatography (SEC) with standard polystyrene, according to JIS K 7252 01 (2008). This also applies to the viscosity average molecular weight described later.

The polyisobutylene is a polymer of isobutylene. The polyisobutylene having a high molecular weight is so mixed into the butyl rubber that flowability of the butyl rubber at a high temperature can be improved, an excellent water vapor barrier property can be maintained, and temperature characteristics can be improved.

The viscosity average molecular weight of the polyisobutylene is in the range of 500,000 to 3,000,000, preferably 700,000 to 2,000,000, or more preferably 900,000 to1,500,000.

If the viscosity average molecular weight of the polyisobutylene is less than the aforementioned range, the sealing composition drips when multiple glass 3 or a solar cell panel 4 described later is assembled. If the viscosity average molecular weight of the polyisobutylene exceeds the aforementioned range, on the other hand, the shape followability is reduced.

The mixing ratio between the butyl rubber and the polyisobutylene is in the range of, e.g., 9/1 to 1/6, or preferably 4/1 to 1/3 on the weight basis thereof.

The mixing ratio of the rubber component to 100 parts by weight of the total amount of the rubber component and the polyolefin is in the range of 40 to 90 parts by weight, or preferably 50 to 80 parts by weight. When the mixing ratio of the rubber component is in the aforementioned range, the water vapor barrier property can be advantageously improved by maintaining rubber elasticity over a wide temperature region.

Examples of the polyolefin include polyethylene (low-density polyethylene such as linear low-density polyethylene, medium-density polyethylene or high-density polyethylene, for example), polypropylene and an ethylene-propylene copolymer. Examples of the polyolefin also include a copolymer of ethylene or propylene and another α-olefin and a copolymer of ethylene and an oxygen-containing ethylenically unsaturated monomer.

Examples of the α-olefin include 1-butene, 1-pentene, 1-hexene and 4-methyl-1-pentene. Examples of the oxygen-containing ethylenically unsaturated monomer include vinyl acetate, acrylic acid, acrylic acid ester, methacrylic acid, methacrylic acid ester and vinyl alcohol.

Examples of a copolymer of the polyolefin include a random copolymer and a block copolymer.

The polyolefin includes crystalline polyolefin, for example.

The softening point (the ring and ball method) of the polyolefin is in the range of, e.g., 100 to 150°C, or preferably 110 to 140°C.

These polyolefins can be used alone or in combination of two or more.

Preferably, the polyethylene, the polypropylene and/or the ethylene-propylene copolymer is used as the polyolefin.

The mixing ratio of the polyolefin to 100 parts by weight of the total amount of the rubber component and the polyolefin is in the range of, e.g., 10 to 60 parts by weight, or preferably 20 to 50 parts by weight.

The polyolefin is so mixed into the sealing composition according to the present invention that the polyolefin exhibits a reinforcing property up to the temperature region of the softening point of the polyolefin, whereby a sealing material made of the sealing composition is hardly deformed under a general working temperature. In heat sealing for lamination (setting on an upper-side glass layer 10 described later) or the like, on the other hand, the elasticity of the sealing composition is reduced below that of the butyl rubber, whereby the flowability of a kneaded mixture (the sealing composition) can be easily adjusted. Further, surface smoothness in molding can be improved, whereby the sealing composition can be molded into a seal material 1 having a predetermined shape without adding wax having a low molecular weight or the like.

The sealing composition according to the present invention contains the aforementioned components as essential components, while containing a hygroscopic compound as an optional component.

The hygroscopic compound is a drying agent adsorbing a volatile component or moisture (absorbing moisture or water) contained in an intermediate layer 6 or a sealing resin layer 9 described later for effectively preventing reduction of the performance of the intermediate layer 6 or the sealing resin layer 9, and optionally mixed into the sealing composition.

Examples of the hygroscopic compound include silica gel, alumina, zeolite (including molecular sieve which is artificial zeolite), activated carbon, boria, titanium oxide, sepiolite and activated clay.

Preferably, silica gel, alumina or zeolite is employed as the hygroscopic compound, in view of hygroscopicity.

The average particle size of the hygroscopic compound is in the range of, e.g., 1 nm to 1000 µm, or preferably 10 nm to 100 µm.

The mixing ratio of the hygroscopic compound to 100 parts by weight of the total amount of the rubber component and the polyolefin is in the range of 0 to 30 parts by weight (not more than 30 parts by weight), or preferably 0 to 20 parts by weight (not more than 20 parts by weight).

If the mixing ratio of the hygroscopic compound exceeds the aforementioned range, the hygroscopic compound disadvantageously excessively absorbs external water and infiltrates the water into the inner portion (the intermediate layer or the sealing resin layer).

A filler and a tackifier can be mixed into the sealing composition according to the present invention, for example.

As the filler, an inorganic filler such as a pigment (an inorganic pigment, for example) is employed. More specifically, examples of the filler include calcium carbonate (heavy calcium carbonate or light calcium carbonate, for example), talc, titanium oxide, carbon black, silica and magnesium oxide. Preferable examples of the filler include calcium carbonate, talc, titanium oxide and carbon black. A more preferable example of the filler is carbon black. These fillers can be used alone or in combination of two or more.

The average particle size of the filler is in the range of, e.g., 1 nm to 1000 µm, or preferably 10 nm to 100 µm.

The mixing ratio of the filler to 100 parts by weight of the total amount of the rubber component and the polyolefin is in the range of, e.g., 1 to 100 parts by weight, or preferably 1 to 10 parts by weight. When the mixing ratio of the filler is in the aforementioned range, the reinforcing property can be improved.

As the tackifier, petroleum resin or hydrocarbon resin (C5-hydrocarbon resin, phenolic resin, rosin, terpene resin or coumarone resin, for example) is employed, for example. Low-molecular weight polyisobuylene can also be employed as the tackifier. The viscosity average molecular weight of the low-molecular weight polyisobutylene is, e.g., less than300,000, specifically in the range of 10,000 to 250,000, or preferably 30,000 to 60,000. These tackifiers can be used alone or in combination of two or more.

Preferably, the coumarone resin or the low-molecular weight polyisobutylene is employed as the tackifier. More preferably, the coumarone resin and the low-molecular weight polyisobutylene are employed together.

The softening point (temperature of deflection under load) is in the range of, e.g., 90 to 140°C, or preferably 100 to 130°C.

The mixing ratio of the tackifier to 100 parts by weight of the total amount of the rubber component and the polyolefin is in the range of 1 to 60 parts by weight, or preferably 2 to 50 parts by weight. When the coumarone resin and the low-molecular weight polyisobutylene are employed together or singly employed, the mixing ratio of the coumarone resin or the low-molecular weight polyisobutylene is in the range of, e.g., 1 to 30 parts by weight, or preferably 2 to 20 parts by weight.

Further, additives such as an antioxidant (hindered phenyl-based), a lubricant, an oxidation inhibitor, another pigment (an organic pigment), an antistatic agent, a plasticizer, a heat stabilizer, a silane coupling agent (a hydrolytic silyl group-containing compound, for example), a foaming agent and another filler (an organic filler), for example, can be added to the sealing composition according to the present invention at appropriate ratios as necessary.

The sealing composition according to the present invention can be obtained as a kneaded mixture by mixing the aforementioned components at the aforementioned ratios and heating and kneading the mixture.

The mixture is kneaded in a batch-type kneader such as a kneader, a Banbury mixer or a mixing roll, or a continuous kneader such as a biaxial kneader, for example. The heating temperature in the kneading is in the range of, e.g., 80 to 130°C, or preferably 90 to 120°C.

The seal material can be obtained by molding the sealing composition obtained in the aforementioned manner into a proper shape.

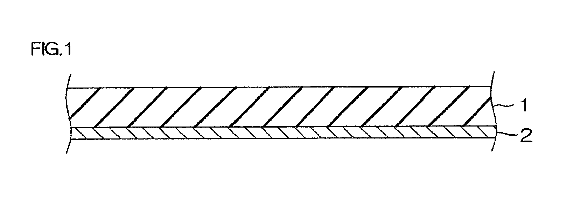

FIG. 1 is a sectional view of an embodiment of a seal material made of the sealing composition according to the present invention.

The seal material made of the sealing composition according to the present invention is now described with reference to FIG. 1.

The sealing composition obtained in the aforementioned manner is heated and molded into a sheet shape, for example, with a molder such as an extruder, a calender roll or a pressing machine (a thermal pressing machine), for example, and the obtained sheet is stacked on the surface of a mold releasing film 2. The sealing composition is molded preferably with the extruder or the calender roll, or more preferably with the calender roll.

The seal material (a first seal material) 1 is obtained in this manner.

The seal material 1 is in the form of a long wide flat strip extending in the longitudinal direction. Alternatively, the mold releasing film 2 can be stacked on the surface (the lower surface) of the seal material 1, and the laminate of the seal material 1 and the mold releasing film 2 can be wound into a roll shape.

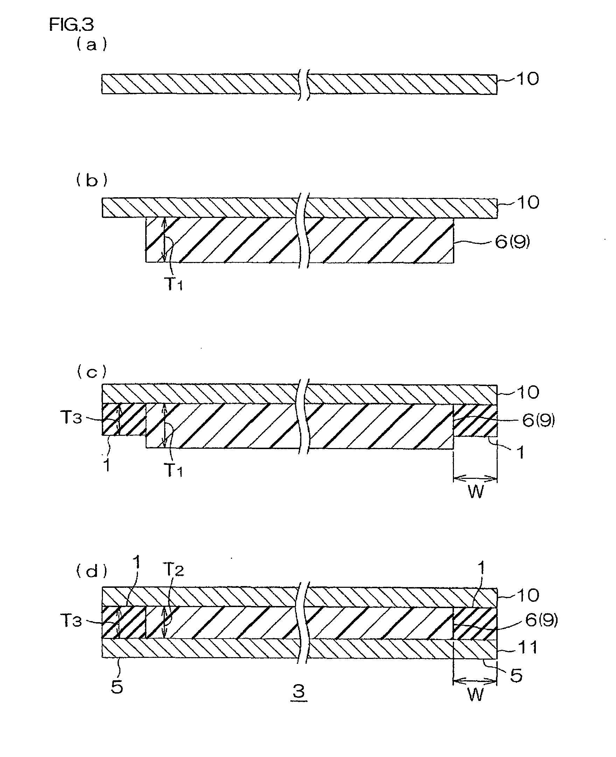

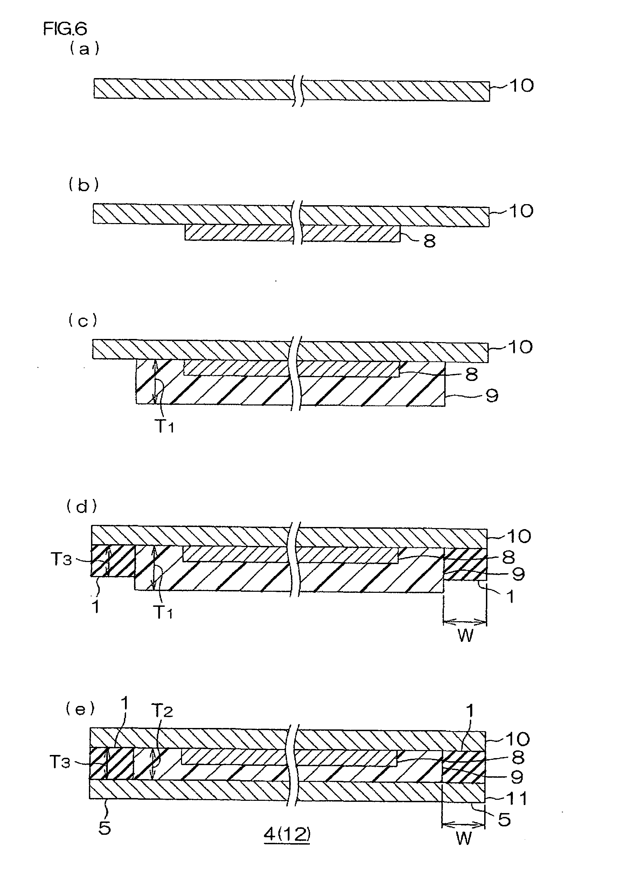

The thickness of the seal material 1 is properly selected in response to the sizes of the intermediate layer 6 and the resin sealing layer 9 as FIGS. 3(d) and 6(e) are referred to, and in the range of, e.g., 0.3 to 2.0 mm, or preferably 0.4 to 1.0 mm.

The width (the length in a direction orthogonal to the longitudinal direction) of the seal material 1 is in the range of, e.g., 5 to 30 mm, or preferably 10 to 20 mm.

The seal material 1 obtained in this manner is employed for sealing various industrial products.

Preferably, the seal material 1 is employed for sealing multiple glass which is also expressed as double glazing and a solar cell panel.

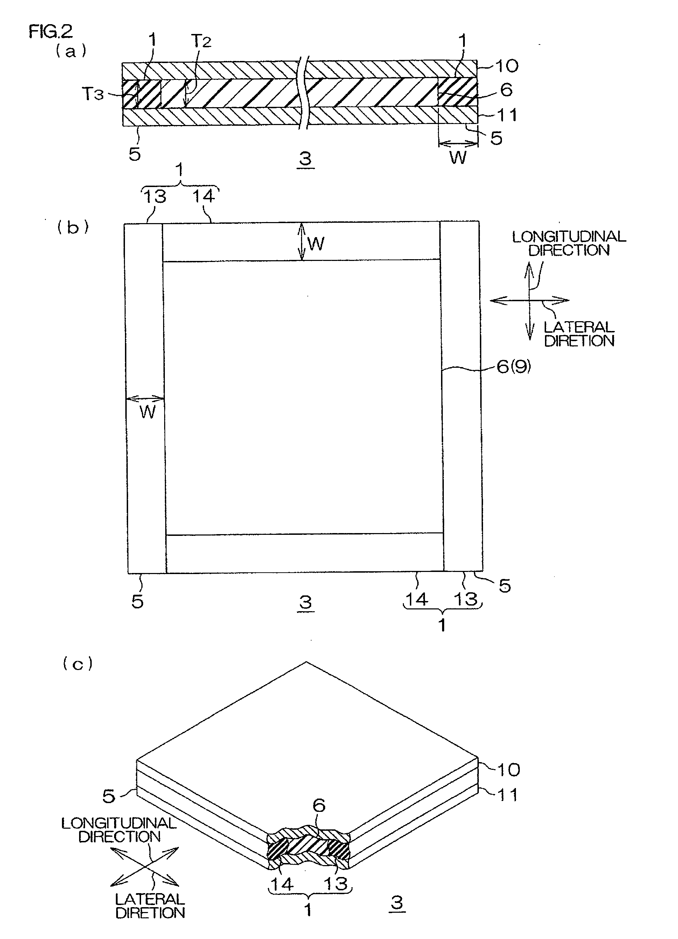

FIG. 2 shows an embodiment (implementation in which four seal materials are provided) of multiple glass according to the present invention, and FIG. 3is step diagrams illustrating a method of manufacturing the multiple glass shown in FIG. 2(a).

Referring to FIG. 2(b), illustration of the upper-side glass layer 10 is omitted, in order to clearly show the relative arrangement of the seal material 1.

The multiple glass having peripheral end portions sealed with the aforementioned seal material 1 is now described with reference to FIGS. 2(a) to 2(c).

Referring to FIG. 2, multiple glass 3 includes the upper-side glass layer 10 and a lower-side glass layer 11 as two glass layers arranged at an interval from each other in the thickness direction, the intermediate layer 6 provided therebetween inside peripheral end portions 5 of the upper-side glass layer 10 and the lower-side glass layer 11, and the seal material 1 filled into the gaps between the peripheral end portions 5 of the upper-side glass layer 10 and the lower-side glass layer 11.

The upper-side glass layer 10 is provided on the uppermost surface (the upper surface) side of the multiple glass 3, and generally in the form of a rectangle in plan view. The thickness of the upper-side glass layer 10 is 0.5 to 3.2 mm, for example.

The lower-side glass layer 11 is provided on the most opposite surface (the lower surface) side of the multiple glass 3, and generally in the form of a rectangle having the same size as the upper-side glass layer 10 in plan view. The thickness of the lower-side glass layer 11 is 0.5 to 3.2 mm, for example.

The intermediate layer 6 is generally in the form of a rectangle smaller than the upper-side glass layer 10 and the lower-side glass layer 11 in plan view.

The material for the intermediate layer 6 which is the material for a sealing resin layer 9 described later is not particularly restricted. Specifically, examples of the material include resin materials such as an ethylene-vinyl acetate copolymer (EVA), polyvinyl butyral (PVB) and polyvinylidene fluoride. The thickness of the intermediate layer 6 is 0.5 to 1 mm, for example.

The seal material 1 seals the intermediate layer 6. The seal material 1 includes two longitudinal seal materials 13, generally in the form of rectangles in plan view, extending in the longitudinal direction and two lateral seal materials 14, generally in the form of rectangles in plan view, extending in the lateral direction to be in contact with both end portions of the longitudinal seal materials 13 in the longitudinal direction respectively.

The longitudinal seal materials 13 are filled into the gaps between the lateral end portions of the upper-side glass layer 10 and the lower-side glass layer 11 in the thickness direction. The lateral seal materials 14 are filled into the gaps between the longitudinal end portions of the upper-side glass layer 10 and the lower-side glass layer 11 in the thickness direction.

The method of producing the aforementioned multiple glass 3 is now described with reference to FIGS. 1 and 3.

According to the method, the upper-side glass layer 10 is first prepared, as shown in FIG. 3(a).

Then, the sealing resin layer 9 as the intermediate layer 6 is arranged on the lower surface of the upper-side glass layer 10, as shown in FIG. 3(b).

The sealing resin layer 9 is arranged to expose the peripheral end portions 5 of the upper-side glass layer 10.

The sealing resin layer 9 is not yet press-bonded as described later, and hence the thickness T1 thereof is set to be larger than the thickness T3 of the seal material 1, for example. More specifically, the thickness T1 is set to the range of 0.4 to 2.0 mm, or preferably 0.5 to 1.2 mm.

Then, the seal material 1 including the aforementioned longitudinal and lateral seal materials 13 and 14 is arranged in the aforementioned manner, as shown in FIG. 3(c). The seal material 1 is arranged (heat-sealed) in a melted state as necessary.

The thickness T3 of the seal material 1 is smaller than the thickness T1 of the aforementioned sealing resin layer 9 (the sealing resin layer 9 not yet press-bonded), for example, and specifically in the range of, e.g., 50 to 90 %, or preferably 60 to 80 % of the thickness T1. More specifically, the thickness T3 of the seal material 1 is in the range of, e.g., 0.3 to 1.6 mm, or preferably 0.4 to 0.9 mm.

If the thickness T3 of the seal material 1 exceeds the aforementioned range, workability in bonding to the lower-side glass layer 11 may be reduced, or gas generated from the sealing resin layer 9 (acetic acid gas generated from EVA, for example) and/or air may not escape but bubbles remain in the sealing resin layer 9.

If the thickness T3 of the seal material 1 is less than the aforementioned range, on the other hand, sealability for the peripheral end portions 5 of the multiple glass 3 may not be sufficiently ensured.

According to the method, the lower-side glass layer 11 is thereafter bonded to the sealing resin layer 9 and the seal material 1, as shown in FIG. 3(d).

In order to bond the lower-side glass layer 11 to the sealing resin layer 9 and the seal material 1, the lower-side glass layer 11 is brought into contact with the lower surface of the sealing resin layer 9, and press-bonded upward. The lower-side glass layer 11 can be press-bonded by thermocompression bonding, for example.

The thermocompression bonding is performed at a temperature in the range of, e.g., 100 to 160°C, or preferably 110 to 150°C, with a pressure in the range of, e.g., 0.05 to 0.5 MPa, or preferably 0.05 to 0.2 MPa, for a thermocompression bonding time in the range of, e.g., 1 to 60 minutes, or preferably 10 to 30 minutes.

The sealing resin layer 9 is compressed by the press bonding, so that the thickness T2 of the sealing resin layer 9 (the press-bonded sealing resin layer 9) and the thickness T3 of the seal material 1 are generally identical to each other.

Thus, the multiple glass 3 having the peripheral end portions 5 filled up with the seal material 1 can be obtained.

The aforementioned seal material 1 is so excellent in shape followability at ordinary temperature that the same can be set on the upper-side glass layer 10 and the lower-side glass layer 11 at ordinary temperature. Therefore, the seal material 1 can be prevented from extruding from the peripheral end portions 5 under heating conditions (the thermocompression bonding conditions 100 to 160°C and 0.05 to 0.5 MPa for 1 to 60 minutes, for example) for melting the seal material 1, thereby reliably sealing the peripheral end portions 5 of the multiple glass 3.

The sealing composition with excellent in insulation property, water resistance, water vapor barrier property and durability can impart excellent insulation property, water resistance, water vapor barrier property and durability to the peripheral end portions 5 of the multiple glass 3, thereby effectively preventing reduction of the performance of the multiple glass 3.

The intermediate layer 6, formed as a resin layer (sealing resin layer 9) made of resin in the above description, may alternatively be formed as an air layer made of air or inert gas (nitrogen, for example), or as a vacuum layer brought into a vacuum state (or a decompressed state).

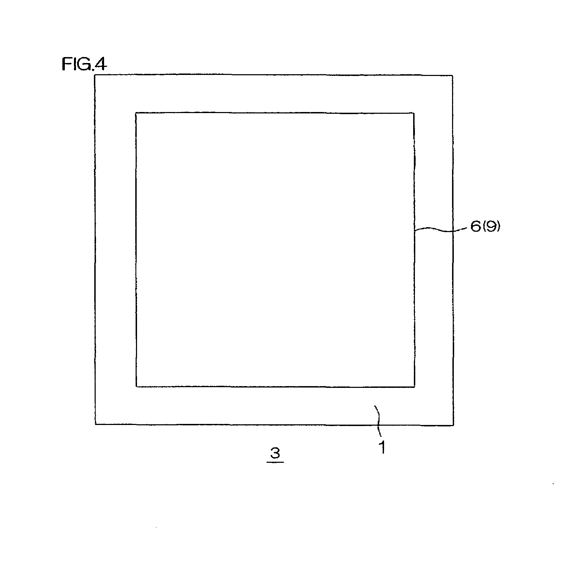

FIG. 4 is a plan view of a solar cell module (implementation in which one seal material is provided).

The seal material 1, formed by four seal materials (the two longitudinal seal materials 13 and the two lateral seal materials 14) generally rectangular in plan view in the above description, may alternatively be formed by one seal material, as shown in FIG. 4, for example.

The seal material 1 can be obtained by a method (not shown) of molding the sealing composition into a generally rectangular shape in plan view with the aforementioned molder and thereafter punching the center (the longitudinal center and the lateral center) thereof, for example.

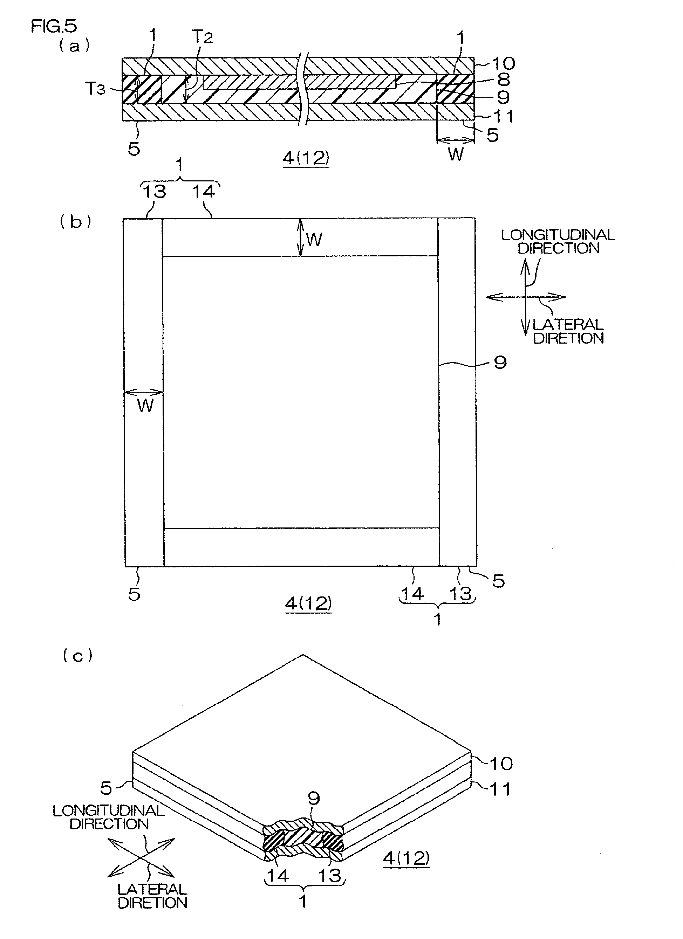

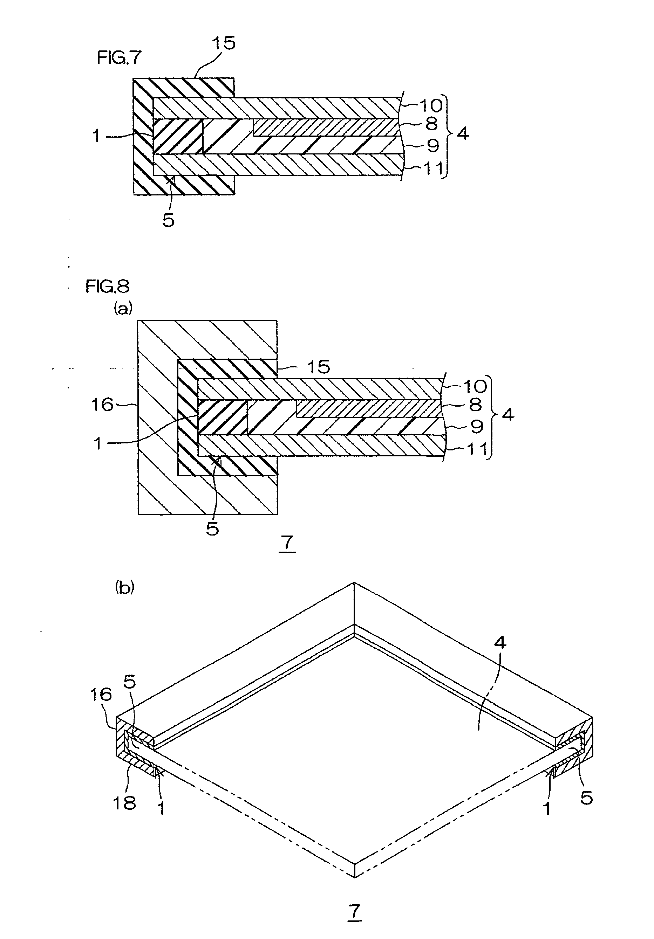

FIG. 5 shows an embodiment of a solar cell panel according to the present invention, FIG. 6is step diagrams illustrating a method of producing the solar cell panel shown in FIG. 5(a), FIG. 7 is a partially enlarged sectional view of a frameless solar cell module (a frameless solar cell module provided with a second seal material) including the solar cell panel shown in FIG. 5, and FIG. 8is explanatory diagrams of a solar cell module (a solar cell module provided with a frame) including the solar cell panel shown in FIG. 5.

The solar cell panel having peripheral end portions sealed with the aforementioned seal material is now described with reference to FIGS. 5 and 6.

In the drawings described below, members corresponding to the aforementioned portions are denoted by the same reference numerals respectively, and redundant description thereof is omitted.

Referring to FIG. 5, the solar cell panel 4 includes an upper-side glass layer 10 as a glass layer, a lower-side glass layer 11 as a support layer arranged at an interval from the upper-side glass layer 10 downward, a solar cell element 8 arranged inside peripheral edge portions 5 of the upper-side glass layer 10 and the lower-side glass layer 11 and a sealing resin layer 9 sealing the same, both provided between the upper-side glass layer 10 and the lower-side glass layer 11, and a seal material 1 filled into the gaps between the peripheral end portions 5 of the upper-side glass layer 10 and the lower-side glass layer 11.

Examples of the solar cell element 8 include well-known solar cell elements such as a crystalline silicon solar cell element and an amorphous silicon solar cell element. The solar cell element 8 is generally in the form of a rectangular flat plate in plan view, and arranged on central portions of the upper-side glass layer 10 and the lower-side glass layer 11 in plan view.

The solar cell element 8 is stacked on the lower surface of the upper-side glass layer 10. The thickness of the solar cell element 8 is smaller than that of the sealing resin layer 9, and specifically, in the range of, e.g., 0.15 to 0.20 mm.

The sealing resin layer 9 seals the solar cell element 8.

The seal material 1 seals the sealing resin layer 9.

The method of producing the aforementioned solar cell panel 4 is now described with reference to FIG. 6.

According to the method, the solar cell element 8 is first arranged on the lower surface of the upper-side glass layer 10, as shown in FIGS. 6(a) and 6(b).

Then, the sealing resin layer 9 is arranged, as shown in FIG. 6(c).

The sealing resin layer 9 is arranged to cover the solar cell element 8 and to expose the peripheral end portions of the upper-side glass layer 10.

Then, the seal material 1 is arranged, as shown in FIG. 6(d).

According to the method, the lower-side glass layer 11 is bonded to the sealing resin layer 9 and the seal material 1, as shown in FIG. 6(e).

In order to bond the lower-side glass layer 11 to the sealing resin layer 9 and the seal material 1, the lower-side glass layer 11 is brought into contact with the lower surface of the sealing resin layer 9, and press-bonded upward. In the press bonding, the lower-side glass layer 11 is thermocompression-bonded under vacuum (decompression), for example.

Thus, the solar cell panel 4 having the peripheral end portions 5 sealed with the seal material 1 can be obtained.

In the solar cell panel 4, reduction of power generation efficiency can be effectively prevented, in addition to the aforementioned functions and effects of the multiple glass 3.

The support layer of the present invention, described as the lower-side glass layer 11 in the above description, can alternatively be formed as a lower-side resin layer (a back sheet) 11 made of resin such as moisture-permeable resin, for example.

The aforementioned solar cell panel 4 shown in FIG. 5can be employed as a frameless solar cell module 12 employing no frame, or can be employed also as a solar cell module 7 provided with a frame, as shown in FIG. 8.

As shown in FIG. 7, the frameless solar cell module 12 can also be employed as a frameless solar cell module 12 having a well-known seal material (a second seal material) 15 provided on the peripheral end portions 5 of the solar cell panel 4.

Referring to FIG. 7, the second seal material 15 has a generally U-shaped section opening inward toward the solar cell panel 4, arranged on each peripheral end portion 5 of the solar cell panel 4, and is continuously formed on the circumferential surfaces and the upper surface of the upper-side glass layer 10, the circumferential surfaces of the first seal material 1, and the circumferential surfaces and the lower surface of the lower-side glass layer 11.

Referring to FIG. 8, the solar cell module 7 includes the solar cell panel 4, a frame 16 provided on the peripheral end portions 5 of the solar cell panel 4, and a second seal material 15 interposed therebetween.

The frames 16 are provided along the respective sides of the solar cell panel 4 respectively. The frame 16 has a generally U-shaped section opening inward toward the solar cell panel 4. The frame 16 is made of a metallic material (aluminum or the like) or a resin material (acrylic resin or the like), for example, or preferably made of the metallic material.

Longitudinal end portions of the frames 16 along the respective sides are bonded to one another to form four corners as shown in FIG. 8(b), and the frames 16 are combined with one another so that the frame 16 is generally rectangular frame in plan view. Examples

While the present invention is now described in more detail with reference to Examples and Comparative Examples, the present invention is not restricted to the Examples.

Examples 1 to 3 and Comparative Examples 1 to 7

In each of Examples 1 to 3 and Comparative Examples 1 to 7, components described in Table 1 were introduced into a kneader (having the model number DS1-5GHB-E, a 1 L kneader provided with an open roll of six inches, manufactured by Moriyama Company Ltd.) at one time and kneaded at 120°C, to prepare a sealing composition as a kneaded mixture.

Then, a seal material made of the sealing composition was obtained by calendering the obtained kneaded mixture into a thickness of 0.75 mm and a thickness of 1.0 mm respectively with a calender roll (a calender roll 4L-8a manufactured by Hitachi, Ltd.). In the calender roll, the roll temperature was adjusted to 30 to 90°C, and the ratio (R'/R) of the rolling speed (R') of a downstream-side roll arranged on a downstream side of an upstream-side roll in the transfer direction to the rolling speed (R) of the upstream-side roll was adjusted to 1.1.

Thereafter a mold releasing film was stacked on one surface of the seal material, and wound into a roll (see FIG. 1). Then, both end portions in the width direction were cut (width-worked) so that the roll had a predetermined width.

Comparative Example 8

A seal material was obtained from components shown in Table 1 with a calender roll, similarly to the above.

Table 1

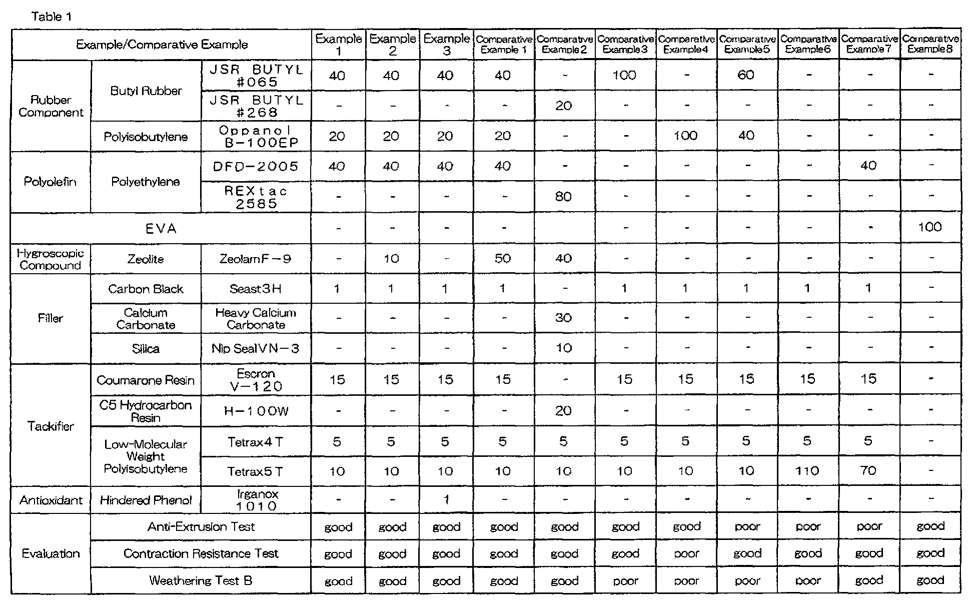

The details of the components in Table 1 are as follows:
JSR BUTYL #065: butyl rubber having a degree of unsaturation of 0.8 mole % and Mooney viscosity of 32 (ML₁₊₈, 125°C), produced by JSR Corporation
JSR BUTYL #268: butyl rubber having a degree of unsaturation of 1.5 mole % and Mooney viscosity of 51 (ML₁₊₈, 125°C), produced by JSR Corporation
Oppanol B-100EP: polyisobutylene having a viscosity average molecular weight of 1,100,000, produced by BASF Japan Ltd.
DFD-2005: crystalline polyethylene having a density of 0.92 g/cm³, produced by Nippon Unicar Co., Ltd.
REXtac 2585: an amorphous ethylene-propylene random copolymer having a softening point (ASTM E 28, ball and ring method) of 129°C, produced by Huntsman Corporation
EVA: an ethylene-vinyl acetate copolymer having a vinyl acetate content of 33 %
Zeolam F-9: zeolite having an average particle size of 150 µm, produced by Tosoh Corporation
Seast 3H: carbon black having an average particle size of 27 nm, produced by Tokai Carbon Co., Ltd.
Nip Seal VN-3: silica having an average particle size of 20 µm, produced by Nippon Silica Industrial Co., Ltd.
Escron V-120: coumarone resin having a softening point (temperature of deflection under load) of 120°C, produced by Nitto Chemical Co., Ltd.
H-100W: C5 hydrocarbon resin, produced by Eastman Chemical Company
Tetrax 4T: polyisobutylene having a viscosity average molecular weight of 40,000, produced by Nippon Oil Corporation
Tetrax 5T: polyisobutylene having a viscosity average molecular weight of 50,000, produced by Nippon Oil Corporation
Irganox 1010: a hindered phenol antioxidant, produced by Ciba Specialty Chemicals Inc.

### (Evaluation)

The seal material obtained according to each of Examples and Comparative Examples was evaluated as to respective items of (1) a high temperature and humidity resistance test, (2) a moisture resistance test, (3) a water vapor barrier property test A, (4) a water vapor barrier property test B, (5) a weathering test A, (6) an anti-extrusion test, (7) a contraction resistance test and (8) a weather resistant test B.

The details of the evaluation are as follows:

### (1) High Temperature and Humidity Resistance Test

The seal material having the thickness of 0.75 mm according to each of Examples 1 and 2 and Comparative Examples 1, 2 and 8 was introduced into a thermo-hygrostat of 85°C and 85 % RH, to measure volume resistivity of the seal material after a predetermined moisture absorption time. The volume resistivity was measured by the double ring method employing a digital ultra-insulation/micro ammeter (having the model number of DSM-8104, produced by Hioki E. E. Corporation).

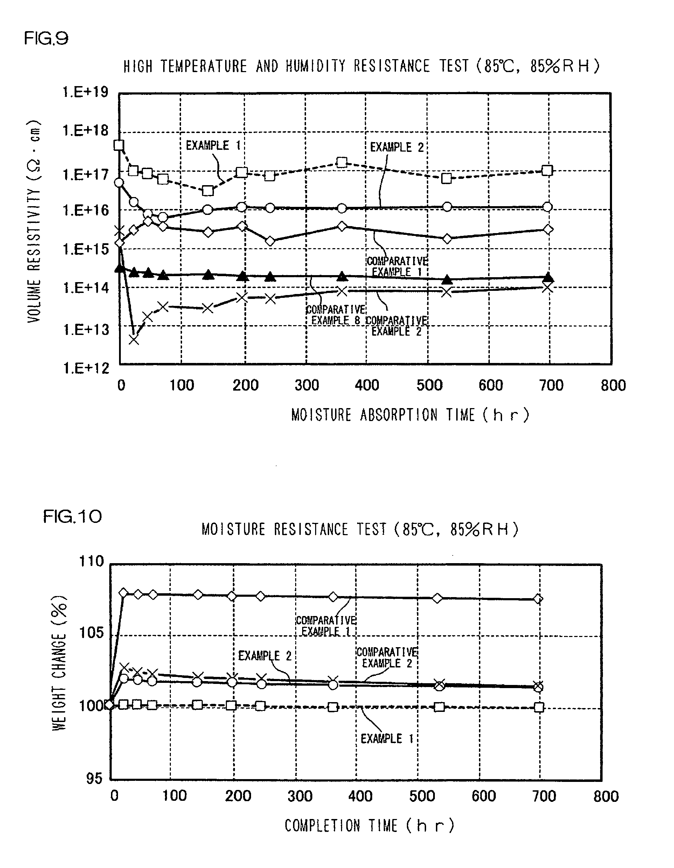

FIG. 9 shows the results.

### (2) Moisture Resistance Test

The seal material having the thickness of 0.75 mm according to each of Examples 1 and 2 and Comparative Examples 1 and 2 was introduced into a thermo-hygrostat of 85°C and 85 % RH, to measure weight change of the seal material after a predetermined completion time.

FIG. 10 shows the results.

### (3) Water Vapor Barrier Property Test A

A cup test (the water vapor barrier property test A) was conducted on the seal material having the thickness of 0.75 mm according to each of Examples 1 and 2 and Comparative Example 2 according to JIS Z0208. Table 2 shows the results.

Table 2

**Table 2**

| Water Vapor Barrier Property TestA (J I S Z 0208) | Example 1 | Example 2 | Comparative Example 2 |
|---|---|---|---|
| Moisture Permeability (g/m²·day) | 0.5 | 1.4 | 2.4 |

### (4) Water Vapor Barrier Property Test B

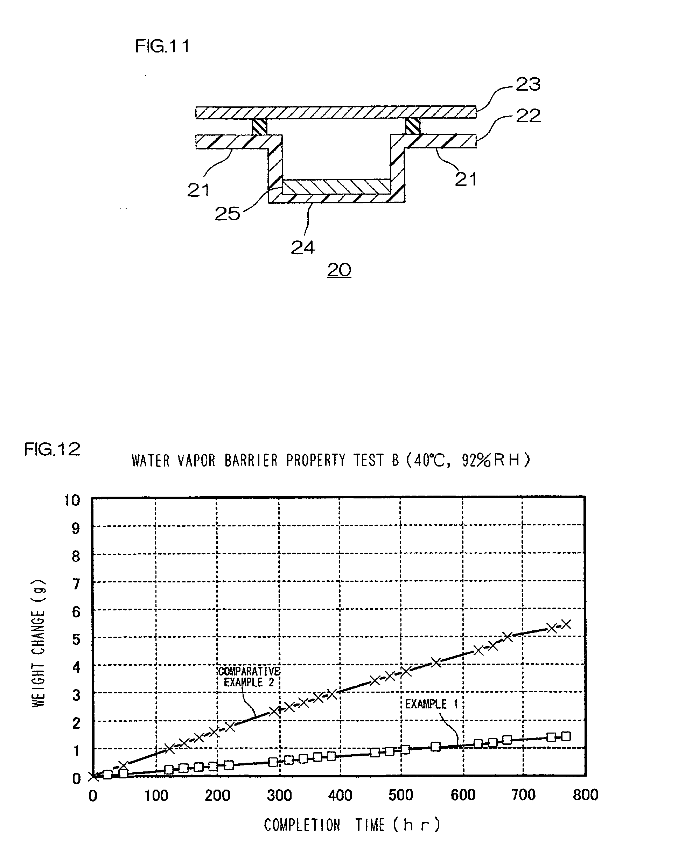

The water vapor barrier property test B was conducted on the seal material having the thickness of 0.75 mm according to each of Example 1 and Comparative Example 2 with a measuring apparatus described below. FIG. 12 shows the results.

As shown in FIG. 11, a measuring apparatus 20 includes a bottomed cylindrical cup 22 provided with a flange 21 on the upper end portion thereof and a glass plate 23 opposed to the flange 21 at an interval in the thickness direction. The cup 22 is made of aluminum and includes a bottom wall 24 having a depth of 15 mm, and has an inner diameter of 60 mm.

In the measuring apparatus 20, a moisture absorber 25 is uniformly stacked on the upper surface of the bottom wall 24 of the cup 22. The moisture absorber 25 is made of calcium chloride, and has a weight of 10 g.

The seal material 1 according to each of Example 1 and Comparative Example 2 was cut into a width of 5 mm to correspond to the planar shape of the flange 21 and thereafter put on the upper surface of the flange 21, and the glass plate 23 was thereafter thermocompression-bonded to the seal material 1 at 150°C, to seal the cylinder of the cup 22. Thereafter the apparatus 20 was introduced into thermo-hygrostat of 45°C and 92 % RH, to measure weight change of the overall apparatus 20 after a predetermined completion time. In the aforementioned thermocompression bonding, it was confirmed that the seal material 1 did not drip.

### (5) Weathering Test A (Accelerated Weathering Test)

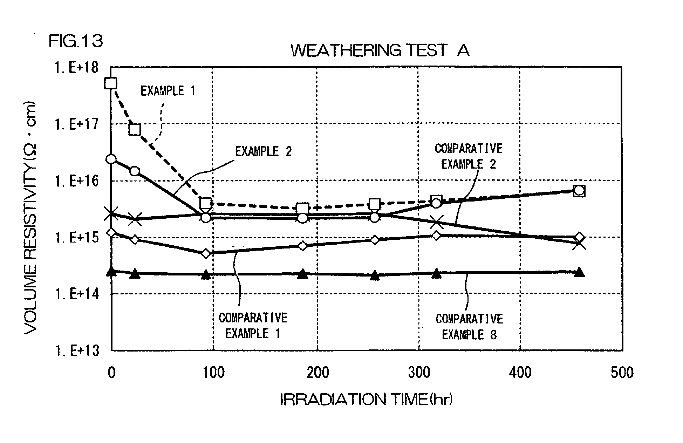

The seal material having the thickness of 0.75 mm according to each of Examples 1 and 2 and Comparative Examples 1, 2 and 8 was introduced into an acceleration weathering tester (Super Xenon Weather Meter SX75, produced by Suga Test Instruments) and irradiated in a dose of 180 (W/m²), to measure the volume resistivity of the seal material after a predetermined irradiation time. FIG. 13 shows the results.

### (6) Anti-Extrusion Test

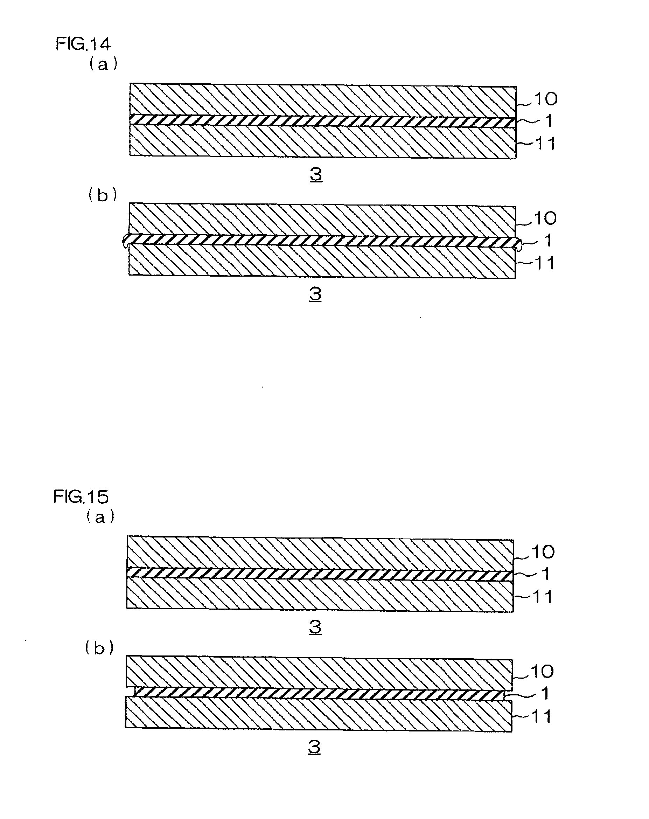

As shown in FIGS. 14(a) and 14(b), multiple glass (3) (including no intermediate layer (6)) was prepared by sandwiching the seal material (1) having the thickness of 1.0 mm according to each of Examples 1 to 3 and Comparative Examples 1 to 8 between an upper-side glass layer (10) and a lower-side glass layer (11), and subjected to the anti-extrusion test. Table 1 shows the results.

In other words, the seal material (1) of 10 by 10 cm having the thickness of 1.0 mm was bonded to the surface (the lower surface) of the upper-side glass layer (10), identical in size to a mold releasing film (2), made of white tempered glass having a thickness of 3.2 mm. Then, the mold releasing film (2) was separated from the seal material (1), which in turn was bonded to the surface (the upper surface) of the lower-side glass layer (11), identical in size to the mold releasing film (2), made of white tempered glass having a thickness of 3.2 mm. Then, the upper-side glass layer (10) and the lower-side glass layer (11) were compression-bonded to each other under vacuum (see FIG. 14(a)). The compression bonding under vacuum was executed in the following application device under the following compression bonding conditions:

Application Device: a vacuum pressing machine (having the model number of MS-VPF-50, manufactured by Meisho-Press Co., Ltd.)
Compression Bonding Conditions: (1) under vacuum, 0.1 MPa, room temperature, nine minutes

### (2) 0.1 MPa, room temperature, one minute under room temperature after (1)

Thereafter the weight of portions (extruding portions) of the seal material (1) extruding from the peripheral end portions of the upper-side glass layer (10) and the lower-side glass layer (11) heated at 150°C for 10 minutes under the atmosphere (see FIG. 14(b)) was measured, to calculate the weight ratio of the extruding portions to the total weight of the seal material (1). Then, the anti-extrusion property of the seal material (1) was evaluated from the weight ratio of the extruding portions according to the following criteria:

(Criteria)

good: The weight of the extruding portions was less than 5 %.

poor: The weight ratio of the extruding portions was not less than 5 %.

### (7) Contraction Resistance Test

The extruding portions were removed so that the circumferential end surfaces of the upper-side glass layer (10) and the lower-side glass layer (11), and the circumferential end surfaces of the seal material (1) of the multiple glass (3) after the anti-extrusion test (6) were flush with one another in the thickness direction (see FIG. 15(a)).

Thereafter the multiple glass (3) was left at ordinary temperature for three days.

Then, the presence or absence of contraction of the seal material (1) was observed, to evaluate contraction resistance according to the following criteria. Table 1 shows the results.

good: The circumferential end surfaces of the seal material (1) were not generally retracted inward, but were flush with the circumferential end surfaces of the upper-side glass layer (10) and the lower-side glass layer (11).

poor: The circumferential end surfaces of the seal material (1) were retracted inward from the peripheral end surfaces of the upper-side glass layer (10) and the lower-side glass layer (11).

When the result of the contraction resistance test is evaluated as "poor", the area of the seal material (1) in plan view is reduced, and hence this indicates a low water vapor barrier property.

When the result of the contraction resistance test is evaluated as "good", on the other hand, reduction of the area of the seal material (1) in plan view can be prevented, and hence this indicates an excellent water vapor barrier property.

### (8) Weathering Test B

The weathering test B was conducted on the seal material having the thickness of 0.75 mm according to each of Examples 1 to 3 and Comparative Examples 1 to 8. Table 1 shows the results.

The conditions for the weathering test B were as follows:

Weathering Tester: accelerated weathering tester (Super Xenon Weather Meter SX75, manufactured by Suga Test Instruments)

Dose: 180 (W/m²)
Irradiation Time: 100 hours

Then, the irradiated seal material was visually observed, to evaluate weathering resistance according to the following criteria:

good: No change was confirmed on the surface of the seal material.

poor: Change such as cracking was confirmed on the surface of the seal material.

## Claims

1. A sealing composition containing a rubber component and polyolefin, wherein the rubber component contains butyl rubber and polyisobutylene having a viscosity average molecular weight in the range of 500,000 to3,000,000,
the mixing ratio of the rubber component to 100 parts by weight of the total amount of the rubber component and the polyolefin is in the range of 40 to 90 parts by weight, and
the sealing composition contains 0 to 30 parts by weight of a hygroscopic compound with respect to 100 parts by weight of the total amount of the rubber component and the polyolefin.

2. The sealing composition according to Claim 1, wherein
the polyolefin is at least one type selected from polyethylene, polypropylene and an ethylene-propylene copolymer.

3. The sealing composition according to Claim 1, containing a filler in the range of 1 to 100 parts by weight with respect to 100 parts by weight of the total amount of the rubber component and the polyolefin.

4. The sealing composition according to Claim 3, wherein
the filler is at least one type selected from a group consisting of calcium carbonate, talc, titanium oxide and carbon black.

5. The sealing composition according to Claim 1, wherein
the hygroscopic compound is at least one type selected from a group consisting of silica gel, alumina and zeolite.

6. The sealing composition according to Claim 1, containing a tackifier, wherein
the tackifier contains coumarone resin having a softening point of 90 to 140°C and/or polyisobutylene having a viscosity average molecular weight of 30,000 to 60,000 each in the range of 1 to 30 parts by weight with respect to 100 parts by weight of the total amount of the rubber component and the polyolefin.

7. The sealing composition according to Claim 1, employed for sealing an end portion of multiple glass.

8. Multiple glass comprising:
two glass layers arranged at an interval from each other in the thickness direction;
an intermediate layer provided between the glass layers and arranged inside end portions of the glass layers; and
a sealing material, filled into the gap between the end portions of the glass layers to seal the intermediate layer, made of a sealing composition, wherein the sealing composition contains a rubber component and polyolefin,
the rubber component contains butyl rubber and polyisobutylene having a viscosity average molecular weight in the range of 500,000 to 3,000,000,
the mixing ratio of the rubber component to 100 parts by weight of the total amount of the rubber component and the polyolefin is in the range of 40 to 90 parts by weight, and
the sealing composition contains 0 to 30 parts by weight of a hygroscopic compound with respect to 100 parts by weight of the total amount of the rubber component and the polyolefin.

9. The sealing composition according to Claim 1, employed for sealing an end portion of a solar cell panel.

10. A solar cell panel comprising:
a glass layer;
a support layer arranged at an interval from the glass layer in the thickness direction;
a solar cell element provided between the glass layer and the support layer and arranged inside end portions of the glass layer and the support layer, and a sealing resin layer sealing the solar cell element; and
a seal material, filled into the gap between the end portions of the glass layer and the support layer to seal the sealing resin layer, made of a sealing composition, wherein
the sealing composition contains a rubber component and polyolefin, the rubber component contains butyl rubber and polyisobutylene having a viscosity average molecular weight in the range of 500,000 to 3,000,000,
the mixing ratio of the rubber component to 100 parts by weight of the total amount of the rubber component and the polyolefin is in the range of 40 to 90 parts by weight, and
the sealing composition contains 0 to 30 parts by weight of a hygroscopic compound with respect to 100 parts by weight of the total amount of the rubber component and the polyolefin.

## Patentansprüche

1. Dichtungszusammensetzung, die eine Kautschukkomponente und Polyolefin enthält, wobei die Kautschukkomponente Butylkautschuk und Polyisobutylen mit einem durchschnittlichen Viskositätsmolekulargewicht im Bereich von 500000 bis 3000000 enthält,
wobei das Mischungsverhältnis der Kautschukkomponente zu 100 Gewichtsanteilen der Gesamtmenge der Kautschukkomponente und des Polyolefins im Bereich von 40 bis 90 Gewichtsanteilen liegt, und
wobei die Dichtungszusammensetzung 0 bis 30 Gewichtsanteile einer hygroskopischen Verbindung, bezogen auf 100 Gewichtsanteile der Gesamtmenge der Kautschukkomponente und des Polyolefins, enthält.

2. Dichtungszusammensetzung nach Anspruch 1, wobei
das Polyolefin wenigstens eine Sorte ist, die aus Polyethylen, Polypropylen und einem Ethylen-Propylen-Copolymer ausgewählt ist.

3. Dichtungszusammensetzung nach Anspruch 1, die einen Füllstoff im Bereich von 1 bis 100 Gewichtsanteilen, bezogen auf 100 Gewichtsanteile der Gesamtmenge der Kautschukkomponente und des Polyolefins, enthält.

4. Dichtungszusammensetzung nach Anspruch 3, wobei
der Füllstoff wenigstens eine Sorte ist, die aus einer Gruppe ausgewählt ist, die aus Kalziumcarbonat, Talk, Titanoxid und Ruß besteht.

5. Dichtungszusammensetzung nach Anspruch 1, wobei
die hygroskopische Verbindung wenigstens eine Sorte ist, die aus einer Gruppe ausgewählt ist, die aus Silicagel, Aluminiumoxid und Zeolith besteht.

6. Dichtungszusammensetzung nach Anspruch 1, die einen Tackifier enthält, wobei der Tackifier Cumaronharz mit einem Erweichungspunkt von 90 bis 140 °C und/oder Polyisobutylen mit einem durchschnittlichen Viskositätsmolekulargewicht von 30000 bis 60000, jeweils im Bereich von 1 bis 30 Gewichtsanteilen, bezogen auf 100 Gewichtsanteile der Gesamtmenge der Kautschukkomponente und des Polyolefins, enthält.

7. Dichtungszusammensetzung nach Anspruch 1, die zum Abdichten eines Endabschnitts eines Mehrfachglases genutzt wird.

8. Mehrfachglas, das umfasst:
zwei Glasschichten, die in einem Abstand voneinander in der Dickenrichtung angeordnet sind;
eine Zwischenschicht, die zwischen den Glasschichten vorgesehen und innerhalb von Endabschnitten der Glasschichten angeordnet ist; und
ein Dichtungsmaterial, das in den Zwischenraum zwischen den Endabschnitten der Glasschichten gefüllt ist, um die Zwischenschicht abzudichten, wobei das Dichtungsmaterial aus einer Dichtungszusammensetzung hergestellt ist, wobei die Dichtungszusammensetzung eine Kautschukkomponente und Polyolefin enthält,
wobei die Kautschukkomponente Butylkautschuk und Polyisobutylen mit einem durchschnittlichen Viskositätsmolekulargewicht im Bereich von 500000 bis 3000000 enthält,
wobei das Mischungsverhältnis der Kautschukkomponente zu 100 Gewichtsanteilen der Gesamtmenge der Kautschukkomponente und des Polyolefins im Bereich von 40 bis 90 Gewichtsanteilen liegt, und
wobei die Dichtungszusammensetzung 0 bis 30 Gewichtsanteile einer hygroskopischen Verbindung, bezogen auf 100 Gewichtsanteile der Gesamtmenge der Kautschukkomponente und des Polyolefins, enthält.

9. Dichtungszusammensetzung nach Anspruch 1, die zum Abdichten eines Endabschnitts einer Solarzellentafel genutzt wird.

10. Solarzellentafel, die umfasst:
eine Glasschicht;
eine Trägerschicht, die in einem Abstand von der Glasschicht in der Dickenrichtung angeordnet ist;
ein Solarzellenelement, das zwischen der Glasschicht und der Trägerschicht vorgesehen ist und innerhalb von Endabschnitten der Glasschicht und der Trägerschicht angeordnet ist, und eine Dichtungsharzschicht, die das Solarzellenelement abdichtet; und
ein Dichtungsmaterial, das in den Zwischenraum zwischen den Endabschnitten der Glasschicht und der Trägerschicht gefüllt ist, um die Dichtungsharzschicht abzudichten, wobei das Dichtungsmaterial aus einer Dichtungszusammensetzung hergestellt ist, wobei
die Dichtungszusammensetzung eine Kautschukkomponente und Polyolefin enthält,
wobei die Kautschukkomponente Butylkautschuk und Polyisobutylen mit einem durchschnittlichen Viskositätsmolekulargewicht im Bereich von 500000 bis 3000000 enthält,
wobei das Mischungsverhältnis der Kautschukkomponente zu 100 Gewichtsanteilen der Gesamtmenge der Kautschukkomponente und des Polyolefins im Bereich von 40 bis 90 Gewichtsanteilen liegt, und
wobei die Dichtungszusammensetzung 0 bis 30 Gewichtsanteile einer hygroskopischen Verbindung, bezogen auf 100 Gewichtsanteile der Gesamtmenge der Kautschukkomponente und des Polyolefins, enthält.

## Revendications

1. Composition d'étanchéité contenant un composant de caoutchouc et une polyoléfine, dans laquelle
le composant de caoutchouc contient du butylcaoutchouc et du polyisobutylène ayant une masse moléculaire moyenne en viscosité dans la plage de 500 000 à 3 000 000, le rapport de mélange du composant de caoutchouc à 100 parties en poids de la quantité totale du composant de caoutchouc et de la polyoléfine est dans la plage de 40 à 90 parties en poids, et
la composition d'étanchéité contient 0 à 30 parties en poids d'un composé hygroscopique pour 100 parties en poids de la quantité totale du composant de caoutchouc et de la polyoléfine.

2. Composition d'étanchéité selon la revendication 1, dans laquelle :
la polyoléfine est au moins un type choisi parmi le polyéthylène, le polypropylène et un copolymère d'éthylène-propylène.

3. Composition d'étanchéité selon la revendication 1, contenant une charge dans la plage de 1 à 100 parties en poids pour 100 parties en poids de la quantité totale du composant de caoutchouc et de la polyoléfine.

4. Composition d'étanchéité selon la revendication 3, dans laquelle la charge est au moins un type choisi dans un groupe constitué de carbonate de calcium, de talc, d'oxyde de titane et de noir de carbone.

5. Composition d'étanchéité selon la revendication 1, dans laquelle le composé hygroscopique est au moins un type choisi dans un groupe constitué de gel de silice, d'oxyde d'aluminium et de zéolite.

6. Composition d'étanchéité selon la revendication 1, contenant un agent poisseux, l'agent poisseux contenant de la résine de coumarone ayant un point de ramollissement de 90 à 140°C et/ou du polyisobutylène ayant une masse moléculaire moyenne en viscosité de 30 000 à 60 000, chacun dans la plage de 1 à 30 parties en poids pour 100 parties en poids de la quantité totale du composant de caoutchouc et de la polyoléfine.

7. Composition d'étanchéité selon la revendication 1, utilisée pour assurer l'étanchéité d'une partie d'extrémité de vitrage multiple.

8. Vitrage multiple comprenant :
deux couches de verre placées à un intervalle l'une de l'autre dans la direction de l'épaisseur ;
une couche intermédiaire prévue entre les couches de verre et placée à l'intérieur des parties d'extrémité des couches de verre ; et
un matériau d'étanchéité, remplissant l'espace entre les parties d'extrémité des couches de verre pour rendre étanche la couche intermédiaire, composé d'une composition d'étanchéité, la composition d'étanchéité contenant un composant de caoutchouc et une polyoléfine,
le composant de caoutchouc contient du butylcaoutchouc et du polyisobutylène ayant une masse moléculaire moyenne en viscosité dans la plage de 500 000 à 3 000 000,
le rapport de mélange du composant de caoutchouc à 100 parties en poids de la quantité totale du composant de caoutchouc et de la polyoléfine se situe dans la plage de 40 à 90 parties en poids et
la composition d'étanchéité contient de 0 à 30 parties en poids d'un composé hygroscopique pour 100 parties en poids de la quantité totale du composant de caoutchouc et de la polyoléfine.

9. Composition d'étanchéité selon la revendication 1, utilisée pour rendre étanche une partie d'extrémité d'un panneau de cellules solaires.

10. Panneau de cellules solaires comprenant :
une couche de verre ;
une couche de support placée à un intervalle de la couche de verre dans la direction de l'épaisseur ;
un élément de cellule solaire prévu entre la couche de verre et la couche de support et placé à l'intérieur des parties d'extrémité de la couche de verre et de la couche de support, et une couche de résine d'étanchéité assurant l'étanchéité de l'élément de cellule solaire ; et
un matériau d'étanchéité, remplissant l'espace entre les parties d'extrémité de la couche de verre et la couche de support pour assurer l'étanchéité de la couche de résine d'étanchéité, composée d'une composition d'étanchéité, dans lequel la composition d'étanchéité contient un composant de caoutchouc et une polyoléfine,
le composant de caoutchouc contenant du butylcaoutchouc et du polyisobutylène ayant une masse moléculaire moyenne en viscosité dans la plage de 500 000 à 3 000 000,
le rapport de mélange du composant de caoutchouc à 100 parties en poids de la quantité totale du composant de caoutchouc et de la polyoléfine se situe dans la plage de 40 à 90 parties en poids, et
la composition d'étanchéité contient 0 à 30 parties en poids d'un composé hygroscopique pour 100 parties en poids de la quantité totale du composant de caoutchouc et de la polyoléfine.
